# EUROPEAN PATENT APPLICATION

(11) **EP 2 393 120 A1**
(43) Date of publication of application: **07.12.2011**
(21) Application number: 10735788.1
(22) Date of filing: 26.01.2010
(51) Int. Cl.: H01L 31/04

(54) **SOLAR CELL AND METHOD FOR MANUFACTURING SOLAR CELL**

(30) Priority: 27.01.2009 JP 2009015643
(71) Applicant: ULVAC, INC., Chigasaki-shi Kanagawa 253-8543 (JP)
(72) Inventor: SHIMIZU, Miho, Sammu-shi Chiba 289-1226 (JP); SAITO, Kazuya, Sammu-shi Chiba 289-1226 (JP); HASHIMOTO, Masanori, Sammu-shi Chiba 289-1226 (JP)
(74) Representative: Schatt, Markus F.
(86) International application number: PCT/JP2010/050942
(87) International publication number: WO 2010/087320

(57) **Abstract**

A solar cell (1) includes: a substrate (10); a photoelectric conversion cell (11) which has a first electrode layer (12) provided with permeability, a photoelectric conversion layer (13), and a second electrode layer (14), and is arranged on the substrate (10); and a protection layer (20) which covers at least the second electrode layer (14). The protection layer (20) includes a silicon nitride compound.

## Description

### TECHNICAL FIELD

The present invention relates to a solar cell and a method for manufacturing a solar cell.

### BACKGROUND ART

A solar cell, which includes a photoelectric conversion unit that performs photoelectric conversion of sunlight, generally has a back sheet. The back sheet is applied to the back surface of the solar cell to improve the durability with respect to changes in the outdoor environment such as rain, wind, and temperature changes. The back sheet is formed by a stacked sheet in which an aluminum foil is arranged between resin layers, or a sheet containing fluoride resin. Further, the back sheet, the photoelectric conversion unit, and a substrate of the solar cell are integrally laminated by a resin material including ethylene vinyl acetate copolymer (EVA) or the like. The resin material functions as a barrier film that prevents the permeation of moisture into the photoelectric conversion cells in addition to functioning as an adhesive layer that bonds the back sheet to the photoelectric conversion unit or the like.

In the sealing structure of the prior art described above, the photoelectric conversion unit is simply sealed by the resin material. Thus, the permeation of moisture may not be sufficiently prevented. To solve this problem, patent document 1 describes a sealing structure in which an electrode on a back surface of a solar cell is covered by an oxide film such as silicon oxide or aluminum oxide. The oxide film is arranged between the back surface electrode and the resin material.

### PRIOR ART DOCUMENT

### Patent Document:

Patent Document 1
Japanese Laid-Open Patent Publication No. 2001-53305

### SUMMARY OF THE INVENTION

### PROBLEMS TO BE SOLVED BY THE INVENTION

As described above, when the oxide film of silicon oxide or the like is arranged between the back surface electrode and the sealing material, the barrier characteristic is improved compared to a solar cell in which the resin material is stacked on the back surface electrode. However, it is difficult to maintain satisfactory durability over a long period of time outdoors under severe conditions such as strong rain and strong wind. It is thus required that the sealing structure further improve the barrier characteristic to withstand use over a long period of time.

Accordingly, it is an object of the present invention to provide a solar cell and a method for manufacturing the same that further improves the durability in an outdoor environment.

### MEANS FOR SOLVING THE PROBLEM

A solar cell of the present invention includes a substrate, a photoelectric conversion cell arranged on the substrate and including a first electrode layer, which is permeable, a photoelectric conversion layer, and a second electrode layer, and a protective layer that covers at least the second electrode layer. The protective layer contains a silicon nitride compound.

In this structure, the protective layer is arranged between a sealing material and the second electrode layer. The protective layer, which covers the second electrode layer, is insulative and includes a silicon nitride compound, which has a strong barrier characteristic. Thus, even under a situation in which the photoelectric conversion cell of the battery cell is arranged outdoors, the permeation of moisture or the like is prevented. Further, electrical leakage from the second electrode layer is prevented even when permeation of moisture or the like occurs.

The solar cell may further include a sealing material that covers the protective layer. In this case, the protective layer is arranged between the second electrode layer and the sealing material.

In the solar cell, the protective layer may contain silicon nitride. Further, the protective layer may contain silicon nitride including hydrogen.

In this structure, the protective layer contains silicon nitride having a strong barrier characteristic to moisture or the like. This further improves the barrier characteristic.

In the solar cell, the protective layer may contain silicon oxynitride.

In this structure, the protective layer contains silicon oxynitride having a barrier characteristic to moisture or the like. This further improves the barrier characteristic.

In the solar cell, the protective layer may have a stacked structure including a plurality of different films.

In this structure, the protective layer has a stacked structure, and layers are formed in a plurality of stages when forming the protective layer. Thus, a pinhole formed in an underlying layer of the protective layer is discontinued in the film thicknesswise direction, and a pinhole is less likely to grow in the thicknesswise direction. This prevents a pinhole from deteriorating the barrier characteristic.

In the solar cell, the protective layer may include an intermediate film, which is stacked on the second electrode layer and formed from a compound that is free from nitrogen, and a nitride film, which is formed from a silicon nitride compound stacked on the intermediate film.

In this structure, the protective layer stacks the intermediate film on the second electrode layer. Thus, even when the nitride film, which is formed from a silicon nitride compound, is stacked thereon, the photoelectric conversion cell is prevented from being adversely affected. Accordingly, the arrangement of the protective layer prevents deterioration of the photoelectric conversion cell.

In the solar cell, the protective layer may include a metal film or a metal oxide film between the intermediate film and the nitride film.

In this structure, the protective layer includes a metal film or a metal oxide film between the intermediate film and the nitride film and thus prevents the characteristic of the photoelectric conversion cell from deteriorating. This further improves the barrier characteristic of the protective layer.

In the solar cell, the photoelectric conversion cell may be arranged on one surface of the substrate. In this case, the protective layer entirely covers the first electrode layer, the photoelectric conversion layer, and the second electrode layer on the one surface of the substrate. The photoelectric conversion cell is one of a plurality of photoelectric conversion cells electrically connected in series and arranged on the one surface of the substrate. Among the plurality of photoelectric conversion cells, the cells located at both ends are respectively electrically connected to lead wires, and the protective layer is arranged to surround the lead wires. Preferably, the protective layer includes an intermediate film, which is formed from a compound that is free from nitrogen, and a nitride film, which is formed from a silicon nitride compound stacked on the intermediate film. In this case, the lead wires are surrounded by the intermediate film and the nitride film.

Alternatively, in the solar cell, the photoelectric conversion cell may extend across both surfaces of the substrate. In this case, the protective layer covers the second electrode layer on at least one of the surfaces of the substrate. The photoelectric conversion cell is one of a plurality of photoelectric conversion cells electrically connected in series and extending across both surfaces of the substrate. Among the plurality of photoelectric conversion cells, the cells located at both ends are respectively electrically connected to lead wires, and the protective layer is arranged to surround the lead wires. Preferably, the protective layer includes an intermediate film, which is formed from a compound that is free from nitrogen, and a nitride film, which is formed from a silicon nitride compound stacked on the intermediate film. In this case, the lead wires are surrounded by the intermediate film and the nitride film.

A method for manufacturing a solar cell of the present invention includes the steps of forming a photoelectric conversion cell on a substrate, in which the photoelectric conversion cell includes a first electrode layer, which is permeable, a photoelectric conversion layer, and a second electrode layer. The method also includes forming a protective layer containing silicon nitride compound and covering at least the second electrode layer by performing a CVD process.

In this method, a CVD process is performed to form the protective layer on the second electrode layer. The protective layer contains a silicon nitride compound having a strong barrier characteristic. Accordingly, the protective layer, which has a high density, is formed within a short period of time. Thus, even under a situation in which the photoelectric conversion cell of the solar cell is installed outdoors, the durability to rain is improved. Thus, the reliability of the solar cell is increased over a long period of time.

In the method for manufacturing a solar cell, the protective layer may be formed by stacking plural types of films.

In this method, the protective layer undergoes a plurality of stages to stack the plural types of films. Thus, even when a pinhole is formed in an underlying layer of the protective layer, the film defect is discontinued in the next film formation step. This improves the barrier characteristic of the protective layer.

In the method for manufacturing a solar cell, the step of forming a protective layer may include stacking a film formed from a compound that is free from nitrogen, and stacking a film that contains a silicon nitride compound. In this case, the step of forming a protective layer may further include the step of stacking a metal film between the step of stacking a film formed from a compound that is free from nitrogen and the step of stacking a film that contains a silicon nitride compound. Alternatively, the step of forming a protective layer may include repeating for a number of times the step of stacking a film formed from a compound that is free from nitrogen and the step of stacking a film that contains a silicon nitride compound.

In this method, due to the film formed from a compound that is free from nitrogen, the photoelectric conversion cell is prevented from being adversely affected even when the nitride film, which is formed from a silicon nitride compound, is stacked thereon. Further, when stacking the metal film, the characteristics of the photoelectric conversion cell are prevented from deteriorating, and the barrier characteristic of the protective layer is further improved.

In the method for manufacturing a solar cell, the step of forming a protective layer includes stacking a film containing a silicon nitride compound, and stacking a metal film.

### EFFECT OF THE INVENTION

Accordingly, the present invention provides a solar cell and a method for manufacturing the same that further improves the durability in an outdoor environment.

### BRIEF DESCRIPTION OF THE DRAWINGS

Fig. 1 is a cross-sectional view showing the main part of a solar cell module according to a first embodiment;
Fig. 2 is a graph that compares the barrier characteristic of a silicon nitride compound and silicon oxide;
Fig. 3 is a flowchart showing the manufacturing steps of the solar cell module of Fig. 1;
Fig. 4 is a cross-sectional view showing the main parts of a solar cell module in a second embodiment;
Fig. 5 is a graph showing the photoelectric conversion efficiency of amorphous silicon on which an oxide film is formed;
Fig. 6 is a cross-sectional view showing the main parts of a solar cell module in a third embodiment;
Fig. 7 is a schematic diagram showing the manufacturing steps of the solar cell module in the third embodiment; and
Fig. 8 is a cross-sectional view showing the main parts of a solar cell module in another example.

### EMBODIMENTS OF THE INVENTION

### First Embodiment

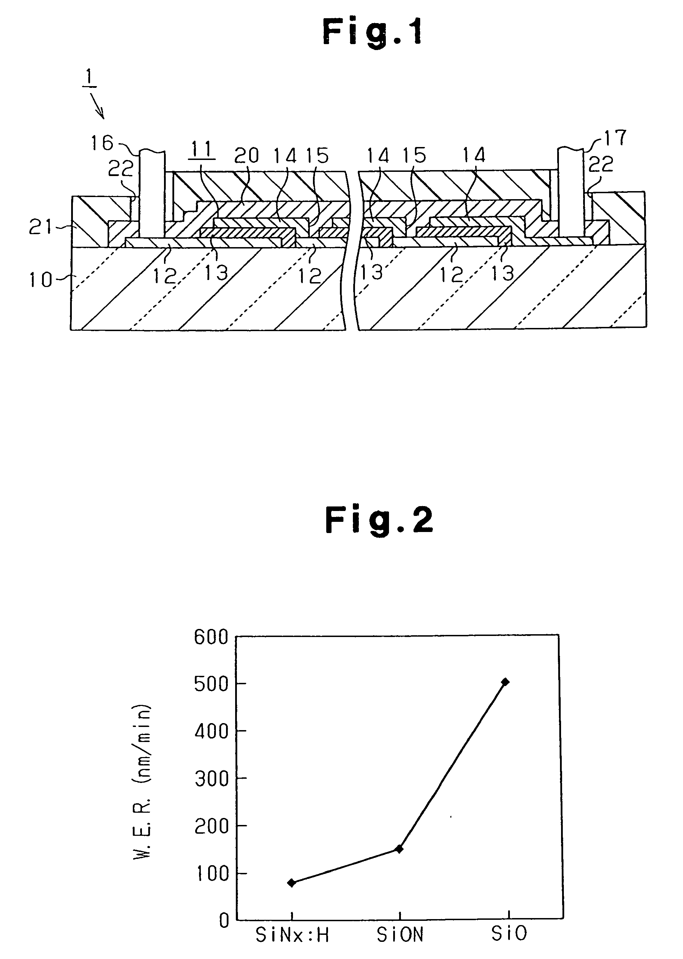

A first embodiment of the present invention will now be described with reference to Figs. 1 to 3.

Fig. 1 is a cross-sectional view showing the main parts of a solar cell module 1. The solar cell module 1 of the present embodiment includes a substrate 10 formed from glass and a plurality of photoelectric conversion cells 11 (hereinafter simply referred to as the cells) on the substrate 10. Each photoelectric conversion cell 11 includes a transparent electrode layer 12, a photoelectric conversion layer 13, and a back surface electrode layer 14. The cells 11, which are separated from one another into strips by cell separation grooves 15, are electrically connected in series. The substrate 10 has a size of 400 mm × 500 mm.

The transparent electrode layer 12 is formed from a transparent conductive film (TCO) such as zinc oxide (ZnO), tin oxide (SnO₂) or indium tin oxide (ITO). The photoelectric conversion layer 13 is formed from an amorphous silicon semiconductor and includes, for example, a p-type layer, an n-type layer, and an i-type layer, which is arranged between the p-type layer and the n-type layer. The photoelectric conversion layer 13 may be a multiple bonding structure (tandem structure) in which silicon layers of different absorption wavelength regions are stacked. The photoelectric conversion layer 13 is connected to the transparent electrode layer 12 of the adjacent cell 11.

The back surface electrode layer 14 is formed from silver, aluminum, or the like. The back surface electrode layer 14 is conducted to the back surface electrode layer 14 of the adjacent cell 11 by the transparent electrode layer 12 of the adjacent cell 11. This forms a series circuit of the cells 11 on the substrate 10.

A protective layer 20 is formed on the cells 11 to cover each cell 11 on the substrate 10. In the present embodiment, the protective layer 20 is a single layer structure formed by a silicon nitride compound. The silicon nitride compound has satisfactory insulating properties, high density, and a property that resists the permeation of moisture or the like. Thus, the silicon nitride compound has a superior barrier function and functions to protect each cell 11. Silicon nitride (SiNx), silicon oxynitride (SiON), silicon carbon nitride (SiCN), or the like may be used as the silicon nitride compound. In particular, silicon nitride (SiNx:H) containing hydrogen is preferable since is has superior density and low moisture permeability. It is further preferable that the oxygen content be decreased for silicon oxynitride and the carbon content be decreased for silicon carbon nitride.

The corrosion resistance of the silicon nitride compound will now be described with reference to Fig. 2. Fig. 2 is a graph showing, with a wet etching rate (WER), the corrosion resistance of a formed of SiNx:H and a formed of SiON, which can be used as the protective layer 20 of the present embodiment, and the corrosion resistance of an oxide formed of SiO. The films are each formed under the temperature of 250°C, and buffered hydrofluoric acid is used for the wet etching.

As shown in Fig. 2, the etching rate of SiNx:H is 80 nm/min and the etching rate of SiON is 150 nm/min. These etching rates are significantly lower than 500 nm/min, which is the etching rate of SiO in a comparative example. Accordingly, it can be understood that the corrosion resistance, or the barrier characteristic, of SiNx:H and SiON is more superior than SiO.

A sealing layer 21, which serves as a sealing material, is formed between the protective layer 20, which is formed of a silicon nitride compound having a strong barrier characteristic, and the back sheet (not shown). The sealing layer 21 is formed of a resin composition, which includes ethylene vinyl acetate copolymer (EVA), and functions as an adhesive layer of the back sheet and the protective layer 20. The sealing layer 21 also functions as a barrier layer that protects each cell 11 from above the protective layer 20.

Among the cells 11, the cells 11 located at the two ends are power collecting cells. A through-hole 22 is formed at a predetermined position in the protective layer 20, which covers the power collecting cell 11. Lead wires 16 and 17, which are used to deliver power to the outer side, are inserted into the through-holes 22. One lead wire 16 is fixed by ultrasonic welding to the transparent electrode layer 12 that forms one of the power collecting cell 11. The other lead wire 17 is fixed by ultrasonic welding to the back surface electrode layer 14 that forms the other one of the power collecting cells.

### Manufacturing Method

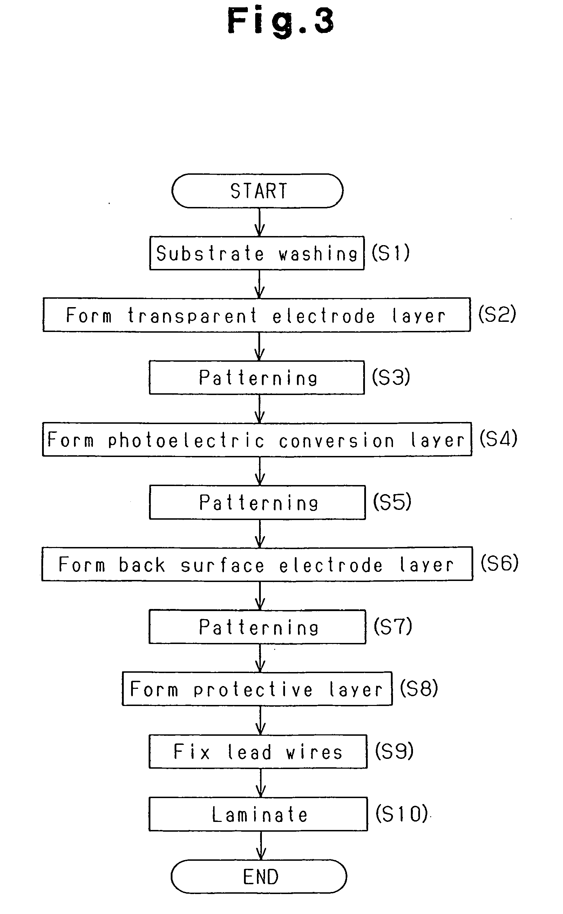

The method for manufacturing the solar cell module 1 will now be described with reference to Fig. 3. The solar cell module 1 is manufactured using a solar cell manufacturing system (not shown) formed by a plurality of devices.

When the substrate 10 is loaded into the solar cell manufacturing system by a substrate transportation device, is by a substrate washing device first washes the substrate 10 to remove foreign matter from the substrate (step S1).

The washed substrate 10 is transported, as a processing subject substrate, to a transparent electrode film formation device. The transparent electrode film formation device is a thermal CVD device, a sputtering device, or the like. The transparent electrode layer 12 is formed on the main surface of the substrate 10 by the transparent electrode film formation device (step S2).

The processing subject substrate on which the transparent electrode layer 12 is formed is washed by a substrate washing device and then transported to a transparent electrode laser etching device, which patterns the transparent electrode (step S3). This separates the transparent electrode layer 12 into strips. The processing subject substrate including the strips of the transparent electrode layer 12 is washed by the washing device.

Next, the processing subject substrate is transported to a photoelectric conversion layer formation device, which forms the photoelectric conversion layer 13 is formed (step S4). This film formation device, which is a plasma CVD (PECVD) device, sequentially forms the p-type layer, the i-type layer, and the n-type layer, which are formed from amorphous silicon, under at least 250°C or less with SiH₄ and H₂ gas as raw materials. This fills the grooves separating the transparent electrode layer 12 with the amorphous silicon and connects the photoelectric conversion layer 13 and the transparent electrode layer 12 between adjacent cells 11.

The processing subject substrate, on which the photoelectric conversion layer 13 has been formed, is transported to a photoelectric conversion layer laser etching device, which patterns the photoelectric conversion layer 13 (step S5). This forms grooves in the photoelectric conversion layer 13 and divides the photoelectric conversion layer 13 into strips.

The processing subject substrate, in which the photoelectric conversion layer 13 has been laser etched, is transported to a back surface electrode film formation device including a sputtering device. The back surface electrode layer 14 is formed on the film surface of the photoelectric conversion layer 13 (step S6). In this case, the back surface electrode layer 14 may have a structure in which a GZO film, which is doped with gallium, and an Ag film are stacked on zinc oxide (ZnO). The grooves separating the photoelectric conversion layer 13 are filled with the back surface electrode layer 14 when the back surface electrode layer 14 is stacked on the photoelectric conversion layer 13. This connects the back surface electrode layer 14 and the transparent electrode layer 12 between adjacent cells 11.

After the back surface electrode layer 14 is formed, the processing subject substrate is transported to a back surface electrode laser etching device, which patterns the back surface electrode layer 14 (step S7). This separates the back surface electrode layer 14 into strips, and forms the cells 11 with each strip of the separated transparent electrode layer 12, photoelectric conversion layer 13, and back surface electrode layer 14. The processing subject substrate is washed after the laser etching of the back surface electrode layer 14 is completed.

The processing subject substrate including the separated cell 11 is transported to a protective layer film formation device, which forms the protective layer 20 that covers each cell 11 (step S8). This protective layer film formation device is a PECVD device or a sputtering device, although a PECVD device is more preferable. In the step of forming the protective layer 20, to prevent the film quality of the photoelectric conversion layer 13 from decreasing, it is desirable that the protective layer 20 be formed around the film formation temperature of the photoelectric conversion layer 13 (more preferably, less than or equal to the film formation temperature), or specifically, less than or equal to 250°C. When the temperature exceeds 250°C, the hydrogen atoms of the photoelectric conversion layer 13 break away and the film quality is greatly reduced. On the other hand, when the protective layer 20 is formed under a low temperature, the atoms that become the raw material are not thermally activated. This makes it difficult to form a film having high density. Accordingly, to form the film at a low temperature of 250°C or less and to increase the density of the protective layer 20, it is desirably in terms of production efficiency to thickly stack a silicon nitride compound within a short time using the PECVD device, which has a high film formation speed. Further, when the protective layer 20 is formed with the PECVD device, advantages are obtained such as being able to maintain satisfactory coverage and to decrease the film stress, even when the shape of a base is complicated shape, as compared to when the protective layer 20 is formed by the sputtering device.

In this case, the various types of raw gas may be used in a ratio in the ranges shown below.

SiH₄:NH₃:N₂O:N₂:H₂ be 1 : 0.1 to 20 : 0.1 to 20 : 0.1 to 50: 0.1 to 50 is preferable. In particular, as for the gas flow rate, SiH₄:100 to 200 sccm, NH₃:50 to 100 sccm, N₂O:50 to 100 sccm, N₂:1300 to 3000 sccm, H₂:500 to 1800 sccm are preferable. Further, it is preferable that a film of 50 nm to 1 µm or less be formed at the pressure of 50 to 200 Pa, a substrate temperature of 100°C to 250°C, and an RF output of 500 to 2000W.

For example, when forming the protective layer 20 of silicon nitride (SiNx:H) with the PECVD device, raw gas is delivered to the device at flow rates of SiH₄:150 sccm, NH₃:50 sccm, N₂:2000 sccm, H₂:1000 sccm, and a film of 50 nm to 1 µm is formed under a pressure of 100 Pa, a temperature of 100°C to 250°C, and an RF output of 1000W. Further, when H₂ is mixed to the raw gas in the same manner as the composition described above, the hydrogen ions in the film formation space strike against the surface of the film that is being formed and applies energy to the elements of the film are energized so that the density of the protective layer 20 can be increased without affecting the composition and the properties of the protective layer 20.

When forming the protective layer 20 from the silicon oxynitride (SiON), in the conditions described above, only the composition of the raw gas is changed and the compositions of SiH₄:150 sccm, NH₃:50 sccm, N₂O:50 sccm, N₂:2000 sccm are delivered to the device.

When forming the protective layer 20 from the silicon oxynitride (SiCN), in the conditions described above, only the composition of the raw gas is changed and the compositions of SiH₄:150 sccm, NH₃:50 sccm, CH₄:50 sccm, N₂:2000 sccm are delivered to the device.

The gas flow rates, substrate temperatures, and RF outputs described are in correspondence with the size of the substrate 10 but may be changed whenever the size of the substrate 10 is changed. In particular, as long as each gas flow rate ratio is maintained, the gas flow rate may be changed in proportion to the substrate area. For example, when using a substrate having a size of 1100 mm × 1400 mm, it is preferable that the flow rate be approximately eight times greater than that described in the example.

It is desirable that the index of refraction of the film of silicon nitride compound be within a constant range. In particular, when measured using a single wavelength laser ellipsometer having a light source wavelength of 632.8 nm, the index of refraction is preferably SiN:1.95 to 2.30, SiON:1.60 to 1.85, and SiCN:1.9 to 2.3. When the index of refraction described above is in other range, the stoichiometrically desirable composition of the silicon nitride compound cannot be obtained and the barrier characteristic is deteriorated.

After the film formation of the protective layer 20 is completed, the films corresponding to the edge portion of the solar cell panel is removed by performing film polishing or the like. Moreover, after the processing subject substrate is loaded into and washed by the washing device, the lead wires 16 and 17 are fixed by ultrasonic welding from the sides of two power collecting cells 11 on the substrate (step S9). This extends the lead wires 16 and 17 through the protective layer 20 for connection to the transparent electrode layer 12 or the back surface electrode layer 14.

Then, the sealing layer 21, which is formed by a resin sheet, and the back sheet are stacked on the protective layer 20 and heated under a depressurized state to perform lamination (step S11). This integrates the solar cell module 1, which includes the substrate 10, the cells 11, and the protective layer 20, with the back sheet through the sealing layer 21. The solar cell module 1 then undergoes a power generation test and included in a panel to complete a solar cell product.

In a solar cell manufactured in such a manner, the protective layer 20 is arranged between the back surface electrode layer 14 and the sealing layer 21. Thus, the barrier characteristic is improved compared to when the sealing layer 21 is directly formed on the back surface electrode layer 14. Further, the durability of the protective layer 20 is increased by forming the protective layer 20 from a silicon nitride compound having a strong barrier characteristic. When the film formation conditions of the protective layer 20 conform to the above conditions using the PECVD process, a film having high density is formed and the barrier characteristic of the protective layer 20 is improved without lowering the properties of each film that forms the cell 11.

The above described embodiment has the advantage described below.
(1) In the above described embodiment, the protective layer 20, which covers at least the back surface electrode layer 14, is arranged between the back surface electrode layer 14 and the sealing layer 21 to serve as a sealing structure on the back surface side of the solar cell module 1. Further, the protective layer 20 is formed from a silicon nitride compound, which is insulative and has a strong barrier characteristic. Since the protective layer 20 is formed through the plasma CVD process (PECVD process), which has a high deposition speed, the protective layer 20, which is highly dense, is formed within a short time even when film formation is carried out under low temperature to suppress the adverse affect on the photoelectric conversion layer 13. Accordingly, the protective layer 20 improves the durability in an outdoor environment of rain or the like even in a situation in which a solar cell panel formed from the solar cell module 1 is installed outdoors. This increases the reliability of the solar cell over a long period of time.

### Second Embodiment

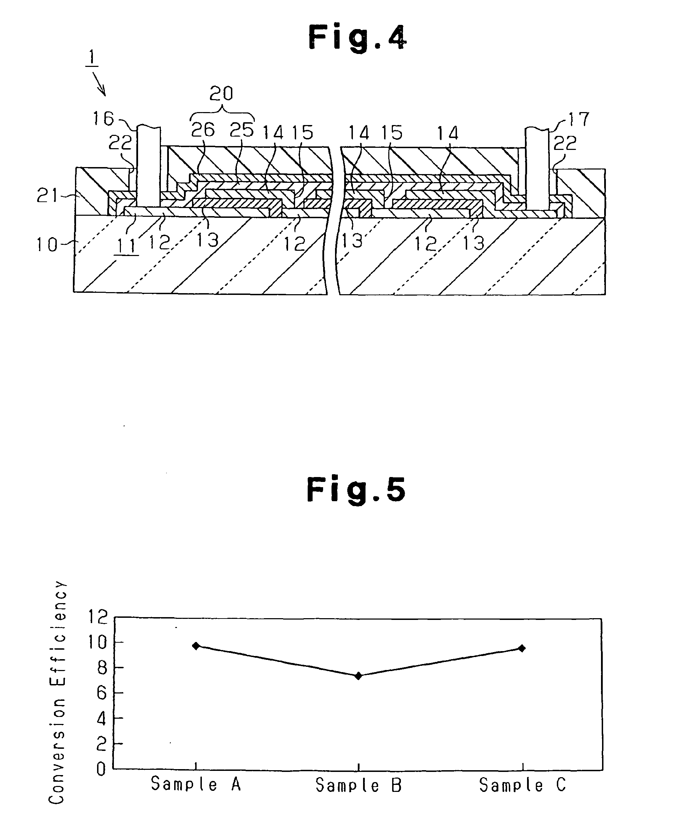

A second embodiment of the present invention will now be described with reference to Figs. 4 and 5. The second embodiment differs from the first embodiment in only the protective layer 20. Thus, similar parts will not be described in detail.

As shown in Fig. 4, the solar cell module 1 of the present embodiment includes the protective layer 20 in which an intermediate film 25 and a nitride film 26 are sequentially stacked on the back surface electrode layer 14. The intermediate film 25 is a film that does not contain nitrogen and may be formed using silicon oxide (SiOx), silicon carbide (SiC), hydrocarbon film (CH), amorphous silicon, or the like. The thickness of the intermediate film 25 is less than or equal to 500 nm. The nitride film 26 is formed from a silicon nitride compound (here, SiNx:H) in the same manner as the first embodiment and has a thickness of less than or equal to 500 nm. In other words, the protective layer 20 is formed such that the entire film thickness is less than or equal to 1 µm.

The intermediate film 25 increases the adhesiveness to the nitride film 26 and the back surface electrode layer 14, and prevents nitrogen ions from adversely affecting the photoelectric conversion layer 13. In other words, when the silicon nitride compound is directly formed on the back surface electrode layer 14, excessive nitrogen ions may be generated in the film formation space in the manufacturing process, the back surface electrode layer 14 may be irradiated with such nitrogen ions including excessive energy, and the nitrogen ions may pass through the back surface electrode layer 14 and enter the photoelectric conversion layer 13. When the nitrogen ions enter the photoelectric conversion layer 13, the transportation of carriers generated in the photoelectric conversion layer 13 may be inhibited by the entering nitrogen ions. When such a phenomenon occurs, there is a tendency for the conversion efficiency of the solar cell to be adversely affected.

Fig. 5 is a graph showing the influence of nitrogen on the amorphous silicon layer. This graph shows the photoelectric conversion efficiencies of sample A including an amorphous silicon layer, sample B including an amorphous silicon layer exposed to N₂ plasma for 30 seconds, and sample C including an oxide film, which is formed from SiO and has 20 nm, on an amorphous silicon layer and exposed to N₂ plasma for 30 seconds from the oxide film side. Samples A to C have the same area. These photoelectric conversion efficiencies do not correspond to the photoelectric conversion efficiency of the solar cell in the present embodiment.

The photoelectric conversion efficiency of sample A is 9.8%, whereas the photoelectric conversion efficiency of sample B is 7.5% and lower than sample A. In contrast, sample C, in which the intermediate film 25 is formed from SiO, has a photoelectric conversion efficiency of 9.7%, which is about the same efficiency as sample A. Accordingly, it is apparent from this result that the intermediate film 25, which is formed from SiO, suppresses corrosion of the photoelectric conversion layer 13.

Further, the protective layer 20 is a stacked structure including the intermediate film 25 and the nitride film 26. This suppresses the growth of film defects such as pinholes when forming the intermediate film 25. More specifically, the film formation step of the protective layer 20 is divided into a step of forming the intermediate film 25 and a step of forming the nitride film 26. This interrupts the growth of a pinhole when forming the intermediate film 25. Once a pinhole is formed, the pinhole has a tendency to grow in the thicknesswise direction. However, such a two-layer structure lowers the possibility of formation of a pinhole that extends through the nitride film 26 at a location of where a pinhole forms when forming the intermediate film 25. Accordingly, moisture is less likely to permeate through the pinhole, and the barrier characteristic of the protective layer 20 is further improved.

The manufacturing process of the present embodiment will now be described. The manufacturing process of the present embodiment differs from the manufacturing process of the first embodiment only in the film formation step of the protective layer 20 (step S8). The other steps are the same.

In the film formation process of the protective layer 20 of the present embodiment, the intermediate film 25 is first formed by the PECVD device so as to cover each cell 11. When the intermediate film 25 is silicon oxide, SiH₄ and N₂O are used as raw gas, and the film 25 is formed by the PECVD device under a temperature of less than or equal to 250°C. When the intermediate film 25 is silicon carbide, dimethyl silane or the like is used as the raw gas, and the film 25 is formed under a low temperature of less than or equal to 250°C. Further, when the intermediate film 25 is a hydrocarbon film, the film 25 is formed by the PECVD device using methane gas, ethane gas, propane gas, acetylene gas, ethylene gas, or the like as the raw gas.

After the intermediate film 25 is formed, the nitride film 26, which is formed from a silicon nitride compound (SiNx:H), is formed on the film surface of the intermediate film 25. The conditions in this case are similar to the conditions described above.

In this manner, by forming the protective layer 20 as a two-layer structure of the intermediate film 25 and the nitride film 26, the protective layer 20 is provided with a strong barrier characteristic without deteriorating the properties of the photoelectric conversion layer 13.

Accordingly, the second embodiment has the following advantage in addition to the advantage of the first embodiment.
(2) In the second embodiment, the protective layer 20 is a stacked structure including the intermediate film 25 and the nitride film 26. Thus, the nitride film 26 is arranged between the nitride film 26 and the photoelectric conversion layer 13. This prevents nitrogen from deteriorating the properties of the photoelectric conversion layer 13. Further, due to the stacked structure, a pinhole formed in an underlying layer (intermediate film 25) of the protective layer 20 tends to easily be discontinued in the film thicknesswise direction, and a pinhole is less likely to grow in the thicknesswise direction. This prevents a pinhole from deteriorating the barrier characteristic.

### Third Embodiment

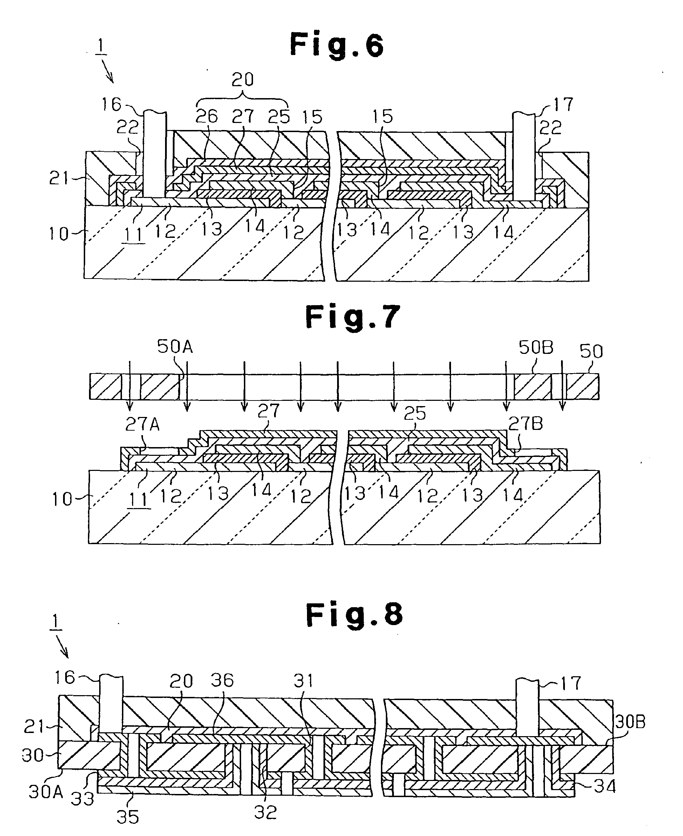

A third embodiment of the present invention will now be described with reference to Figs. 6 and 7. The third embodiment differs from the first embodiment only in the structure of the protective layer 20. Thus, similar portions will not be described in detail.

As shown in Fig. 6, the solar cell module 1 of the present embodiment includes the protective layer 20 having a three-layer structure of the intermediate film 25, a metal film 27, and the nitride film 26, which are sequentially stacked on the back surface electrode layer 14. In the same manner as the second embodiment, the intermediate film 25 is formed from a film (SiO) that does not contain nitrogen. The metal film 27 is formed of aluminum and is arranged between the intermediate film 25 and the nitride film 26 to lower the moisture permeability and further improve the barrier characteristic. In the same manner as the first embodiment, the nitride film 26 is formed from a silicon nitride compound (here, SiNx:H). The protective layer 20 of the present embodiment is formed such that its overall thickness is less than or equal to 1 µm.

The manufacturing process of the present embodiment will now be described. The manufacturing process of the present embodiment differs from the manufacturing process of the first embodiment only in the film formation step of the protective layer 20 (step S8). The other steps are the same.

In the film formation step of the protective layer 20 of the present embodiment, the intermediate film 25, which is formed from SiOx, is first formed by the PECVD device so as to cover each cell 11. SiH₄ and N₂O are used as raw gas, and the film is formed under a temperature of less than or equal to 250°C.

Further, as shown in Fig. 7, the metal film 27 is formed by the sputtering device. Here, insertion portions 27A and 27B, into which the lead wires 16 and 17 are inserted, are formed by covering the processing subject substrate with a mask 50 including shielding portions 50A and 50B, which are formed at locations corresponding to fixing positions of the lead wires 16 and 17. The insertion portions 27A and 27B have larger diameters than the lead wires 16 and 17 so that the lead wires 16 and 17 do not touch the metal film 27 when fixed through the protective layer 20.

After the metal film 27 is formed, the nitride film 26, which is formed from a silicon nitride compound (SiNx:H), is formed on the film surface of the metal film 27. The conditions in this case are similar to the conditions described above. This covers the side surfaces of the insertion portions 27A and 27B in the metal film 27 with the protective layer 20 (nitride film 26). The lead wires 16 and 17 are fixed to the transparent electrode layer 12 or the back surface electrode layer 14 in a state surrounded by the nitride film 26 and the intermediate film 25.

The arrangement of the metal film 27, which has a higher barrier characteristic, between the intermediate film 25 and the nitride film 26 further improves the barrier characteristic of the protective layer 20.

Accordingly, the third embodiment has the following advantage in addition to the advantages of the first embodiment.
(3) In the third embodiment, the protective layer 20 has a three-layer structure in which the intermediate film 25, the metal film 27, and the nitride film 26 are sequentially stacked. Accordingly, the arrangement of the intermediate film 25 prevents the photoelectric conversion layer 13 from being adversely affected while improving the barrier characteristic of the metal film 27 and the nitride film 26.

The above embodiments above may be modified as described below.

Each step of forming the transparent electrode layer 12, the photoelectric conversion layer 13, and the back surface electrode layer 14, and the step of fixing the lead wires 16 and 17 are not limited to the aforementioned methods and may be changed.

The nitride film (protective layer 20), which is formed from silicon oxynitride, may be formed from raw gas having the gas composition of SiH₄, NH₃, CO₂, and N₂. The use of such raw gas forms a SiOCN film of a silicon nitride compound.

In each embodiment described above, the protective layer 20 is stacked after patterning the back surface electrode layer 14. However, the protective layer 20 may be stacked before patterning the back surface electrode layer 14. In this case, the protective layer 20 and the back surface electrode layer 14 are laser etched to separate the back surface electrode layer 14 into strips.

In the second embodiment, the nitride film 26, which is formed from silicon nitride (SiNx:H), is stacked on the intermediate film 25. However, the nitride film 26 may be formed from a silicon nitride compound (SiNx, SiON, SiCN, etc.) other than SiNx:H.

In the second embodiment, the layer including the intermediate film 25 and the nitride film 26 is formed on the back surface electrode layer 14. However, a plurality of layers including the intermediate film 25 and the nitride film 26 may be repeatedly formed. In this case, the intermediate film 25 is stacked on the nitride film 26. Thus, nitrogen carbide easily enters a pinhole formed in the nitride film 26 and prevents the growth of the pinhole.

In the third embodiment, the metal film 27 may be a metal oxide film of alumina or the like. Such a metal oxide film also improves the barrier characteristic of the protective layer 20.

The PECVD process is used in each embodiment described above. However, other CVD processes such as thermal CVD process may be used.

The protective layer 20 may be a two-layer structure in which a first nitride film, which uses a silicon nitride compound, and a second nitride film, which uses a silicon nitride compound differing from that of the first nitride film, are stacked. Alternatively, a plurality of nitride composite layers, each having a two-layer structure of the first nitride film and the second nitride film, may be stacked. In other words, a stacked structure of a first nitride film, a second nitride film, a first nitride film, and so on may be obtained. Such a structure also improves the barrier characteristic of the solar cell module 1.

The protective layer 20 may be a two-layer structure of a nitride film, which is formed from a silicon nitride compound, and a metal film, which is formed from aluminum or the like. In this case, the nitride film is formed on the surface of the back surface electrode layer 14, and the metal film is formed on the nitride film. A plurality of composite layers each including the nitride film and the metal film may be stacked. In other words, a stacked structure of a nitride film, metal film, nitride film, and so on may be obtained. Such a structure also improves the barrier characteristic of the solar cell module 1.

In each of the above embodiments, the back surface side of the solar cell module 1 may be sealed by the glass substrate instead of the back sheet.

In each of the above embodiments, the protective layer 20 is formed in the solar cell module 1 in which each cell 11 including the transparent electrode layer 12, the photoelectric conversion layer 13 formed from amorphous silicon, and the back surface electrode layer 14 is formed on the glass substrate. However, the solar cell module 1 may have other known structures. For example, as shown in Fig. 8, the protective layer 20 may be formed in the solar cell module 1 in which a flexible film 30 formed from plastic is used as the substrate. For example, the film 30 is formed from a heat resistant plastic such as polyimide. Current collection holes 31 and series connection holes 32 extending through the film 30 are formed in advance. A metal electrode 33, a photoelectric conversion layer 34, and a transparent electrode 35 are stacked on a surface 30A of the film 30. The transparent electrode 35 is connected to a back electrode 36 arranged on the back surface 30B of the film 30 through the series connection holes 32. The metal electrode 33 is connected to the back electrode 36 through the current collection holes 31. The protective layer 20 is formed on the back electrode 36 to cover the back electrode 36. The protective layer 20 may employ each structure described above. Further, the protective layer 20 is covered by the sealing layer 21, which is formed from EVA or the like. When metal is not used, the protective layer 20 and the sealing layer 21 may be formed so as to cover the entire surface 30A from the transparent electrode 35. In this example, the transparent electrode 35 corresponds to a first electrode layer and the back electrode 36 corresponds to a second electrode layer, and the protective layer 20 is arranged between the back electrode 36 and the sealing material 21 to at least cover the back electrode 36. In such a solar cell module 1 that uses a film as a substrate, arrangement of the protective layer 20 of each embodiment described above improves the barrier characteristic.

## Claims

1. A solar cell comprising:
a substrate;
a photoelectric conversion cell arranged on the substrate and including a first electrode layer, which is permeable, a photoelectric conversion layer, and a second electrode layer; and
a protective layer that covers at least the second electrode layer;
wherein the protective layer contains a silicon nitride compound.

2. The solar cell according to claim 1, further comprising a sealing material that covers the protective layer, wherein the protective layer is arranged between the second electrode layer and the sealing material.

3. The solar cell according to claim 1, wherein the protective layer contains silicon nitride.

4. The solar cell according to claim 1, wherein the protective layer contains silicon oxynitride.

5. The solar cell according to claim 1, wherein the protective layer contains silicon nitride that contains hydrogen.

6. The solar cell according to any one of claims 1 to 5, wherein the protective layer has a stacked structure including a plurality of different films.

7. The solar cell according to claim 6, wherein the protective layer includes an intermediate film, which is stacked on the second electrode layer and formed from a compound that is free from nitrogen, and a nitride film, which is formed from a silicon nitride compound stacked on the intermediate film.

8. The solar cell according to claim 7, wherein the protective layer includes a metal film or a metal oxide film between the intermediate film and the nitride film.

9. The solar cell according to claim 1, wherein the photoelectric conversion cell is arranged on one surface of the substrate, and the protective layer entirely covers the first electrode layer, the photoelectric conversion layer, and the second electrode layer on the one surface of the substrate.

10. The solar cell according to claim 9, wherein:
the photoelectric conversion cell is one of a plurality of photoelectric conversion cells electrically connected in series and arranged on the one surface of the substrate; and
among the plurality of photoelectric conversion cells, the cells located at both ends are respectively electrically connected to lead wires, and the protective layer is arranged to surround the lead wires.

11. The solar cell according to claim 10, wherein:
the protective layer includes an intermediate film, which is formed from a compound that is free from nitrogen, and a nitride film, which is formed from a silicon nitride compound stacked on the intermediate film; and
the lead wires are surrounded by the intermediate film and the nitride film.

12. The solar cell according to claim 1, wherein the photoelectric conversion cell extends across both surfaces of the substrate, and the protective layer covers the second electrode layer on at least one of the surfaces of the substrate.

13. The solar cell according to claim 12, wherein:
the photoelectric conversion cell is one of a plurality of photoelectric conversion cells electrically connected in series and extending across both surfaces of the substrate; and
among the plurality of photoelectric conversion cells, the cells located at both ends are respectively electrically connected to lead wires, and the protective layer is arranged to surround the lead wires.

14. The solar cell according to claim 13, wherein:
the protective layer includes an intermediate film, which is formed from a compound that is free from nitrogen, and a nitride film, which is formed from a silicon nitride compound stacked on the intermediate film; and
the lead wires are surrounded by the intermediate film and the nitride film.

15. A method for manufacturing a solar cell comprising the steps of:
forming a photoelectric conversion cell on a substrate, wherein the photoelectric conversion cell includes a first electrode layer, which is permeable, a photoelectric conversion layer, and a second electrode layer; and
forming a protective layer containing silicon nitride compound and covering at least the second electrode layer by performing a CVD process.

16. The method for manufacturing a solar cell according to claim 15, wherein the step of forming a protective layer includes forming the protective layer by stacking plural types of films.

17. The method for manufacturing a solar cell according to claim 16, wherein the step of forming a protective layer includes:
stacking a film formed from a compound that is free from nitrogen; and
stacking a film that contains a silicon nitride compound.

18. The method for manufacturing a solar cell according to claim 17, wherein the step of forming a protective layer further includes the step of stacking a metal film between the step of stacking a film formed from a compound that is free from nitrogen and the step of stacking a film that contains a silicon nitride compound.

19. The method for manufacturing the solar cell according to claim 17, wherein the step of forming a protective layer includes repeating for a number of times the step of stacking a film formed from a compound that is free from nitrogen and the step of stacking a film that contains a silicon nitride compound.

20. The method for manufacturing a solar cell according to claim 16, wherein the step of forming a protective layer includes:
stacking a film containing a silicon nitride compound; and
stacking a metal film.
